# EUROPEAN PATENT SPECIFICATION

(11) **EP 1 509 073 B1**
(45) Date of publication and mention of the grant of the patent: **07.04.2010**
(21) Application number: 04078215.3
(22) Date of filing: 01.09.2000
(51) Int. Cl.: H05K 7/14, A63F 13/08

(54) **Electronic device that can be used in either horizontal or vertical orientation**
Elektronische Einrichtung, die entweder in der horizontalen oder vertikalen Lage verwendet werden kann
Dispositif électronique pouvant être utilisé en position horizontale aussi bien qu'en position verticale

(30) Priority: 06.09.1999 JP 25165499
(43) Date of publication of application: 23.02.2005
(62) Divisional of application: 00956877.5
(73) Proprietor: Sony Computer Entertainment Inc., Tokyo 107-0062 (JP)
(72) Inventor: Ootori, Yashuhiro, Minato-ku, Tokyo 107-0062 (JP)
(74) Representative: Hedley, Nicholas James Matthew

(56) References cited:
- EP-A- 0 501 456
- EP-A- 0 576 344
- EP-A- 0 834 793
- WO-A-99/01016
- US-A- 5 163 870
- US-A- 5 248 193
- US-A- 5 369 549

## Description

### BACKGROUND OF THE INVENTION

### Field of the Invention

The present invention relates to an electronic device that has a cabinet inside which a main body of the device is accommodated, and wherein either one of the width, height, and depth dimensions of the cabinet can be its minimum dimension and/or its maximum dimension, so that the device can be used in horizontal orientation, in which its minimum dimension is its height, and in vertical orientation, in which its maximum dimension is its height.

### Background of the Invention

Various cables have long been connected to video game devices and other electronic devices, including power cables, which connect the electronic device with an external power source, and controller cables, which connect the electronic device with a controller. Such cables have been made long in order to have plenty of leeway for making such connections.

Here, the terminals to which cables are connected are attached in various positions, in accordance with the positions of the parts that constitute the electronic device.

Thus when an electronic device is used in vertical orientation, if, for example, a cable for external output is connected at the top of the device and this cable mistakenly gets caught by a foot and gets pulled on, a large angular moment is imparted to the electronic device, and it may topple. For such reasons, electronic devices are usually used in horizontal orientation, and along with this, the design presumes that the electronic device will be used in horizontal orientation.

In recent years such electronic devices are used not simply as video game devices but have come to have various other functions, such as CD player or DVD player, and are becoming a permanent part of people's living rooms.

Thus there has been a desire to allow such equipment to be freely designed to work in either horizontal or vertical orientation, to fit a room's interior layout.

In designing electronic devices so that they can be used in either horizontal or vertical orientation, the switches for controlling the electronic device must be arranged with operability in mind.

US-5369549 discloses a generally rectangular casing for an electronic device that has two parts that are held together by corner elements; the casing can be used in a horizontal or a vertical orientation.

EP-0501456 discloses a game computer having a generally rectangular casing that is used in a horizontal orientation; the casing houses a disk drive.

### SUMMARY OF THE INVENTION

It is an object of this invention to provide an electronic device whose operability can be improved even when used in vertical orientation.

According to the present invention, an electronic device is provided as set out in the accompanying claims. It includes a cabinet accommodating a main body of the device wherein either one of width, height, and depth dimensions of the cabinet is taken as its minimum dimension and another of dimensions thereof is taken as its maximum dimension, and said cabinet can be used in horizontal orientation, in which the minimum dimension is its height, and in vertical orientation, in which the maximum dimension is its height. The cabinet includes an upper case and a lower case, and is formed so that in horizontal orientation thereof the width and depth of said lower case are smaller than the width and depth of said upper case, and so that in vertical orientation bases of said upper case and said lower case match on same plane.

Because the lower ends of the upper case and lower case match in vertical orientation of the device, as a whole the center of gravity tends to be in a lower position, making the electronic device more stable and less prone to toppling. The center of gravity is set even in a lower position, and stability is further increased, if in vertical orientation of the device the disk is located at the top of the cabinet and other heavy parts, such as a power source unit, are provided all together at the bottom.

According to a further feature of the present invention, the electronic device includes terminals to be connected to cables for external input and output which are exposed at the bottom of a side of the cabinet that extends along a height direction of the vertical orientation.

Here, what can be adopted as terminals includes AC inlet and other power supply terminals that supply electronic power to the main body of the electronic device from an external power source, or input-output terminals for providing input and output of signals. As input-output terminals, one can adopt, for example, terminals that conform to the USB (universal serial bus) standards to which an input device such as a keyboard or a pointing device such as a mouse is connected, or, if the electronic device is a video game device, controller connection terminals.

When the electronic device is in vertical orientation, because the terminals are positioned at the bottom, it would be difficult to catch one's foot on a power cable or a controller cable connected to those terminals, and even if a cable is caught by an external force, for example by pulling cable, the angular moment acting on the electronic device will be small, making the electronic device more difficult to tip over than in conventional devices.

Positioning the terminals on the bottom is particularly effective if the electronic device is a video game device, because sometimes, while playing a competitive game or shooting game, a controller cable may be pulled with a strong force.

The electronic device may further include an operation means for operating the main body of the device, the operation means being exposed at the top of said cabinet when said cabinet is in vertical orientation.

When the electronic device is put in vertical orientation, the switches and other operation means are positioned at the top of the electronic device, which can make them more visible and improve the operability when operating the operation means than if they were positioned at the bottom. In particular, it is very effective for operability if they are arranged on the upper end of the upper case.

### BRIEF DESCRIPTION OF THE DRAWINGS

Figure 1 is a schematic, perspective view showing a video game device in an embodiment of the present invention;
Figure 2 is a front view of the video game device of Fig. 1;
Figure 3 is a partial perspective view of video game device of Figs. 1-2;
Figure 4 is an exploded perspective view showing a cabinet of the video game device of the present invention;
Figure 5 is a perspective view showing the interior structure of the video game device of the invention;
Figure 6 is a cross-sectional view along line VI-VI of Figure 5;
Figure 7 is a cross-sectional view showing the heat dissipation and shielding structure of an CPU of the video game device;
Figure 8 is a schematic plane view showing connection positions of an upper case, a center chassis, and a lower case of the cabinet of the video game device;
Figure 9 is a cross-sectional view of the upper part of the device along line IX-IX of Figure 8;
Figure 10 is a cross-sectional view of the lower part of the device along line X-X of Figure 8;
Figure 11 is a cross-sectional view along line XI-XI of Figure 8;
Figure 12 is a front view showing the horizontal orientation of the video game device of the present invention;
Figure 13 is a front view showing the vertical orientation of the video game device of Fig. 12; and
Figure 14 is a schematic perspective view showing a method of use of the video game device in vertical orientation.

### DETAILED DESCRIPTION OF THE PREFERRED EMBODIMENTS

With reference to the drawings, an embodiment of this invention will be now explained.

### (1) Overall composition of the electronic device

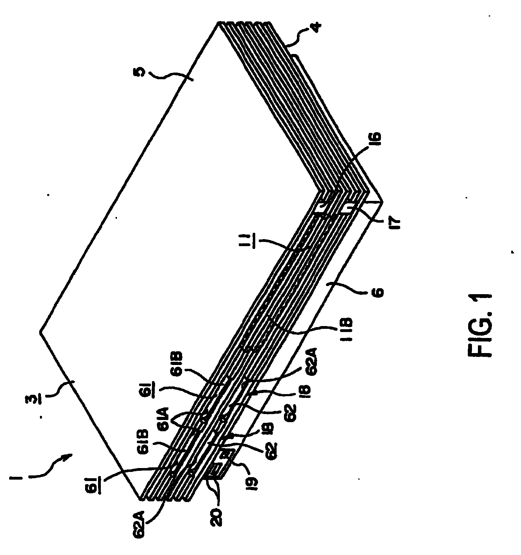

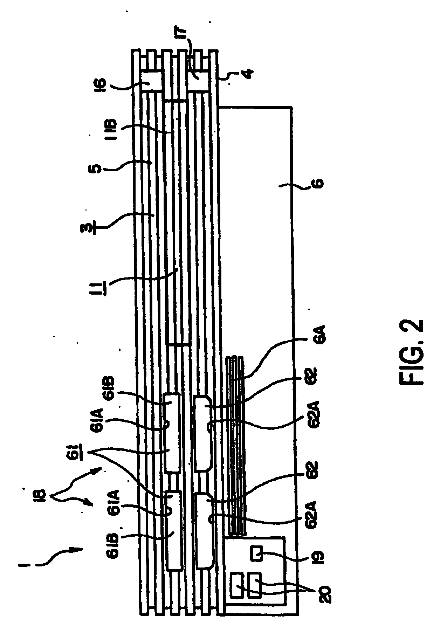

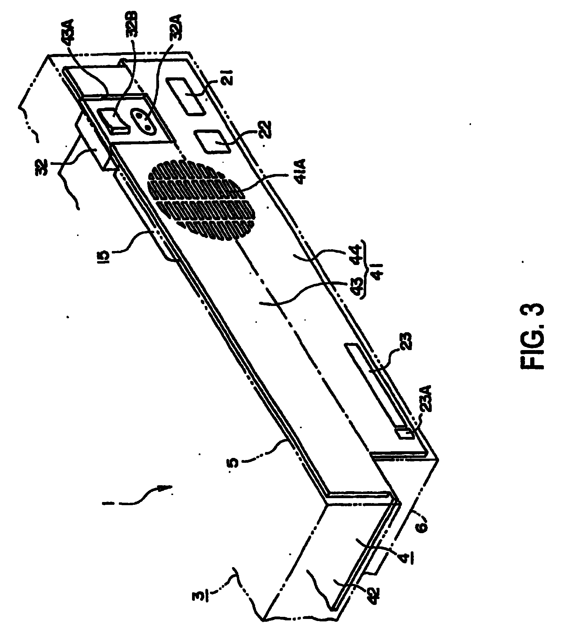

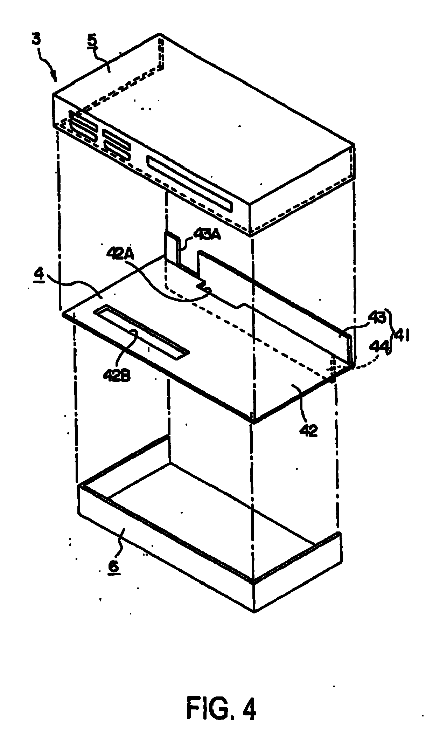

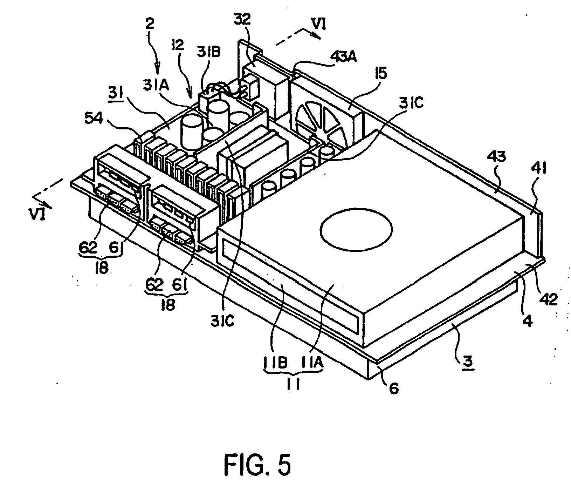

Figures 1 through 5 are schematic views of a video game device 1 which is an electronic device of the present invention, to this wherein; Figure 1 is a perspective view of device 1 seen from above, Figure 2 is a front view of device 1 seen from the front, Figure 3 is a perspective view of device 1 seen from the rear, Figure 4 is an exploded perspective view of a cabinet 3, and Figure 5 is a perspective view of the interior of device 1 seen from above.

Video game device 1, for an example, reads a game program recorded on an optical disk or other medium and executes it according to instructions from the users (game players). "Executing a game" means mainly controlling the progress of the game as well as display and sound.

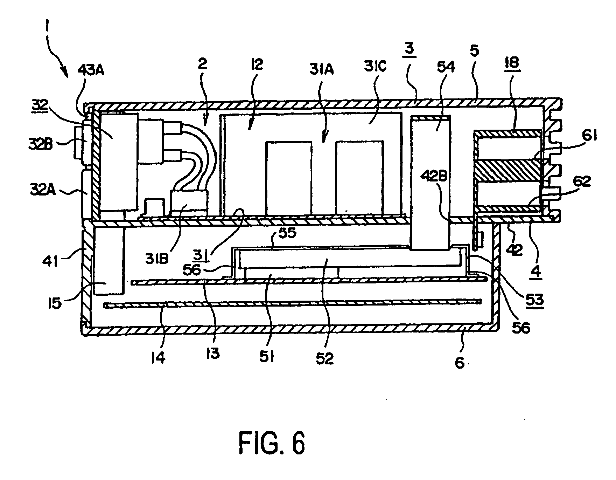

Video game device 1 includes a main body 2 (see Figures 5 and 6) and a cabinet 3, which houses the device main body 2.

As shown in Figure 4, cabinet 3 has a central chassis 4, in which device main body 2 is provided, and an upper case 5 and a lower case 6, which hold central chassis 4 between them and house the device main body 2. The cabinet 3 is formed in a square on the plane and in roughly L shape in front.

As shown in Fig. 1, on the front right side (the right side as seen from the front) of upper case 5 is provided a disk device 11, which controls the operation of a CD-ROM, DVD-ROM, or another optical disk, which is a storage medium on which video game application programs are recorded, and a disk tray 11B of the disk device 11 is exposed.

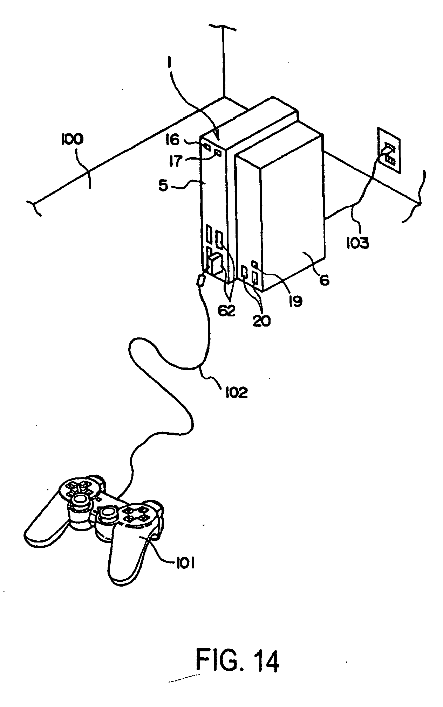

On the right side (the right side as seen from the front) of disk tray 11B are arranged, on top and bottom, an operation means which includes a power switch 16 and a tray operation switch 17 (see Fig. 2 and Fig.14) for performing the operation of inserting the disk tray 11B into and withdrawing it from upper case 5.

On the front left side (the left side as seen from the front) of upper case 5, two slots 18 are exposed. Each slot 18 has a memory card insertion unit 61 positioned at the top and a controller connection unit 62 positioned at the bottom.

A memory card or other external auxiliary memory device is inserted into memory card insertion unit 61, and its insertion hole 61A is formed in the shape of a rectangle that is long in its horizontal direction. Provided on this memory card insertion unit 61 is a shutter 61B for protecting the connection terminal that is provided inside it.

Controller connection unit 62 is an input-output terminal for inputting input signals and outputting output signals. A connection terminal is connected to the controller connection unit 62. The connection terminal is formed at the end of controller cable 102 (see Figure 14), which extends from a controller 101 (see Figure 14) serving as an operation means. The insertion hole 62A, of controller connection unit 62 is formed approximately in the shape of a substantial rectangle that is long in its horizontal direction, with the lower comers shaped rounder than the upper comers.
By forming insertion hole 62A in this way, the connection terminal of controller 101 is prevented from being connected upside-down. Because the shape of insertion hole 62A is given a structure different from the shape of insertion hole 61A for memory card insertion unit 61, there is no danger of mis-inserting an external auxiliary memory device into insertion hole 62A.
Having two of these controller connection units 62 makes it possible to connect two controllers 101, allowing two users to play competitive games, etc.

The results of operating each controller 101 connected to controller connection unit 62 are recorded onto an external auxiliary memory device inserted into memory card insertion unit 61 located above each controller.

The front surface and right-side surface (the side surface on the right side as seen from the front) of lower case 6 lie inside the corresponding front surface and right-side surface of upper case 5 above it. In other words, the width and depth of lower case 6 are smaller than the width and depth of upper case 5, and the volume of lower case 6 is smaller than the volume of upper case 5. On the other hand, the left-side surface (the side surface on the left side as seen from the front) of lower case 6 matches the corresponding surface of upper case 5. Thus cabinet 3 is constructed asymmetrically about the central chassis 4 (see Figures 2 and 6). By adopting such a construction, if for example the cabinet 3 is put into vertical orientation with the left-side surface of lower case 6 and upper case 5 as the base, then lower case 6 will be positioned to a prescribed height from the base (left-side surface) of upper case 5, which lowers the center of gravity of the cabinet as a whole and makes it more stable and harder to tip over.

Exposed on the front left side (the left side as seen from the front) of lower case 6 are data transfer terminal 19 and two external device connection terminals 20 for connecting external devices (see Fig. 2).

Data transfer terminal 19 conforms to the IEEE 1394 standards, and by connecting a cable connected to this terminal to a digital camera or a video deck, etc., one can take into the video game device I a picture and sound, etc. recorded with the digital camera or the video deck.

The two external device connection terminals 20 conform to the USB (universal serial bus) standards and allow one to connect a keyboard or other input device, a mouse or other pointing device, a printer or other printing device, or an external memory device, etc. that employs a magnetooptical disk or other magnetic medium.

Formed on the front of lower case 6, along its longitudinal direction, are slit-like openings 6A (see Fig. 2) for letting in air as cooling air from outside into the interior of device 1.

As shown in Figs. 3 and 4, central chassis 4 has, and is formed integrally with a rear surface part 41, which forms the rear surface of the video game device 1, and a board-like middle shelf 42 which is provided so as to be perpendicular to the middle part of the rear surface part 41 in the height direction.

Rear surface part 41 consists of an upper rear surface part 43 which is formed approximately in the shape of a rectangle and is long enough to block part of the rear surface of the upper case 5, and a lower rear surface part 44, which is formed approximately in the shape of a rectangle and is long enough to block part of the rear surface of the lower case 6.

As shown in Fig. 4, a rectangular notch 43A is formed near the right end edge shown in Fig. 3 of upper rear surface part 43. Arranged in notch 43A, are AC inlet 32A which is a power supply terminal for supplying power from an external power source to main body 2, and a main power switch 32B which operates the supply of power from an external power supply.

Exposed near the right end edge (shown in Fig. 3) of lower rear surface part 44 and below notch 43A, is provided or video-audio output terminal 21 for outputting video, audio and other signals recorded on an optical disk to a television or other display device.

Exposed next to video-audio output terminal 21 is a communication terminal 22 for communicating with external devices. The communication terminal 22 conforms to the IrDA (Infrared Data Association) standards, which are standards for data communication using infrared rays, and if this terminal is provided on an external device, data can be transmitted and received by infrared communication, with no need to connect a cable, etc. between device 1 and the external device.

Exposed near the left end edge of lower rear surface part 44 in Figure 3, is a PCMCIA slot 23, into which are inserted various card-type peripheral devices that conform to the PCMCIA standards, such as a memory card or modem card. A card-type peripheral device inserted into the PCMCIA slot 23 can be removed by pressing an eject button 23A, which is exposed to the side of the PCMCIA slot 23.

Provided approximately in the center of rear surface part 41 is an exhaust opening 41A (Fig. 3), through which the air inside the video game device 1 is expelled.

Middle shelf 42 is formed in the shape of a board having approximately the same width as the upper case 5 and approximately the same depth as the upper case 5, and it is provided at right angles at the interface part of the upper rear surface part 43 and the lower rear surface part 44.

A notch 42A (Fig. 4) for accommodating an exhaust fan 15 (Fig. 3) is formed in the part of this middle shelf 42 that corresponds to exhaust opening 41A provided in rear surface part 41.

### (2) Internal structure of the video game device

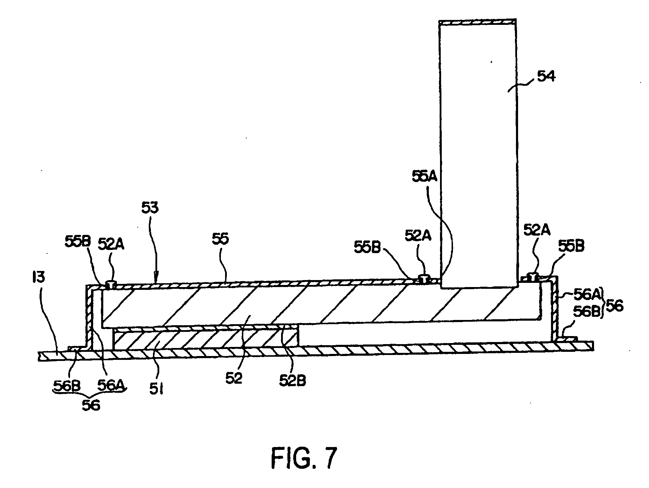

Figures 5-7 show the internal structure of the video game device 1. Figure 5 is a schematic, perspective view of the interior of device 1; Figure 6 is a perpendicular cross-sectional view of video game device 1, and Figure 7 is an enlarged cross-sectional view of the essential parts of the device.

In these drawings, the device main body 2, which is provided on central chassis 4, is built into the interior, which is enclosed by upper case 5 and lower case 6.

The main body 2 of the device has a disk device 11, a power source unit 12, a main board 13, which is the main control circuit board, and an input-output signal control board 14, etc.

Here, disk device 11 and power source unit 12 are arranged on middle shelf 42 of central chassis 4, and main board 13 and input-output signal control board 14 are arranged in layers in the space that is formed by the middle shelf 42 and lower case 6.

Power source unit 12 has a power source circuit board 31 which is mounted on middle shelf 42 of central chassis 4, and a power source unit 32, into which electric power is input from an external power source.

Power source unit 32 has the aforesaid AC inlet 32A and main power switch 32B, and is connected to the power source circuit board 31 via a connector 31B. That is, electric power from an external power source is supplied to power source circuit board 31 through AC inlet 32A by turning on the main power switch 32B.

Power source circuit board 31 occupies approximately half the plane area of middle shelf 42, and electric power supplied from an external power source is converted to the prescribed voltage by capacitors, coils, transformers, and another circuit element 31A that make up the power source circuit board 31. Here, provided on power source circuit board 31 is flat L-shaped guide plate 31C for directing the cooling air in the prescribed direction. The cooling air is brought in through opening 6A formed in the front surface of the lower case 6.

In this way, power source unit 12 supplies to disk device 11 and boards 13, 14, etc. the power that is obtained by power source circuit board 31.

Attached on the side of exhaust outlet 41A of the power source unit 12 is the exhaust fan 15 in a position that corresponds to the exhaust outlet 41A. The exhaust fan 15 is also driven by the electric power from power source unit 12.

Arranged on the side of exhaust outlet 41A of power source unit 12 and near opening 6A on the opposite side, are rectangular heat sinks 54 and slots 18 described below.

Disk device 11 which plays a CD-ROM, DVD-ROM, or other optical disk, includes a main body 11A, inside which an optical pickup unit (not shown) is accommodated, and the disk tray 11B, by which an optical disk is loaded onto the main body 11A, and it is placed on the middle shelf 42 in the space next to power source unit 12.

With the above arrangement, the power source unit, etc. (the relatively heavy parts) are positioned on the left side of the cabinet in horizontal orientation and in the bottom of the cabinet in vertical orientation, and the disk device (relatively light parts) is positioned on the right side of the cabinet in the horizontal orientation an din the top of the cabinet in the vertical orientation. This lowers the center of gravity by positioning mainly the heavy parts, for example, the parts other than the disk device, at the bottom.

The main board 13, which has a control system (not shown) includes a central processing unit (CPU) 51 and its peripheral devices, etc., a graphic system (not shown) consisting of image processing device that renders pictures, and a sound system (not shown) consisting of audio processing device that generates music and sound effects, etc., and the main board 13 is provided in a position closest to and opposite the lower surface of middle shelf 42.

The control system has CPU 51, a peripheral device controller that performs interrupt control and control of direct memory access (DMA) data transfers, etc., a main memory that consists of random access memory (RAM), and a read-only memory (ROM) in which are stored programs such as so-called operating system, which controls the main memory, graphic system, and sound system, etc. The "main memory" here refers to the memory in which programs can be executed.

CPU 51, which controls video game device 1 as a whole by executing the operating system stored in ROM, consists of, for example, a 128-bit RISC (reduced instruction set computer) CPU.

The graphic system has an image processing device that renders pictures under drawing instructions from CPU 51, and a frame buffer in which images rendered by this image-processing device are stored.

The image-processing device draws polygons, etc. to the frame buffer in accordance with drawing commands from CPU 51. The image-processing device is able to draw up to about 75 million polygons per second.

The sound system has an audio processing device that plays background music and sound effects, etc. under instructions from CPU 51, and a sound buffer in which waveform data, etc. is stored by this audio processing device.

Attached to the top of CPU 51 by adhesive 52B is a heat conducting member 52, which is made of high-thermal-conductivity aluminum. Provided on the upper surface of the heat conducting member 52 are multiple T-shaped pins 52A spaced at prescribed intervals.

CPU 51 and heat conducting member 52 are covered by a shielding member 53, which is made of metal.

More specifically, shielding member 53 includes a flat shielding part 55, which comes into contact with the upper surface of heat conducting member 52, and side shielding parts 56, which have an L-shaped cross-section extending from both ends of the flat shielding part 55 to the upper surface of main board 13.

Formed on flat shielding part 55 are holes 55B, which are positioned to correspond to pins 52A provided on the upper surface of heat conducting member 52. That is, by inserting pins 52A into holes 55B and making the upper part of pins 52A protrude against the upper surface of the flat shielding part 55, the flat shielding part 55 is engaged by pins 52A and is anchored onto heat conducting member 52.

Each side shielding part 56 has a vertical part 56A, which extends downward from the end of flat shielding part 55, and a horizontal part 56B, which extends horizontally outward from the end of the vertical part 56A and whose lower surface comes into contact with the upper surface of main board 13.

Providing the shielding member 53 makes it easy to keep outside disturbances such as noise generated from input-output signal control board 14 or power source unit 12 from intruding into CPU 51, and makes it possible to securely maintain the stable operation of CPU 51.

A rectangle-shaped rectangular heat sink 54 is provided on the upper surface of the end of heat conducting member 52. The rectangular heat sink 54 extends from the upper surface of heat conducting member 52 to near the top of upper case 5. Thus, as shown in Figures 4 and 7, openings 42B, 55A are formed in middle shelf 42 and flat shielding part 55 in positions corresponding to the position where rectangular heat sink 54 is provided.

Thus, by transmitting the heat generated by CPU 51 along heat conducting member 52 and rectangular heat sink 54 and dissipating it within device 1, CPU 51 can be cooled in a simple manner. Moreover, by taking in cooling air through opening 6A and exhausting the heat that builds up within device 1 outside of device 1 by means of exhaust fan 15, it becomes easy to further improve the cooling effect on CPU 51.

An input-output signal control board 14, which is arranged below the main board 13, has an optical disk controller (not shown) that performs control of the optical disk on which application programs are recorded, as well as a communication controller that controls the input and output, etc. of signals from controller 101 into which instructions from the users are input, signals that are output to controller 101, and data from external auxiliary memory devices that store video game settings, etc.

The optical disk controller has a decoder that decodes the programs and data, etc. that are recorded with, for example, an appended error correction code (ECC), and a buffer that speeds up the reading of data from the optical disk by temporarily storing data from disk device 11.

Electrically connected to the communication controller is one end of slots 18 (not shown), which has the controller connection unit 62 and the memory card insertion unit 61. With these units are controlled the input and output of signals from controller 101 into which instructions from the users are input, signals that are output to controller 101, and data from external auxiliary memory devices that store video game settings, etc. Also electrically connected to the communication controller are, besides slots 18, data transfer terminal 19, external device connection terminal 20, communication terminal 22, and PCMCIA slot 23, etc., by which the communication controller also controls the input and output of signals with external devices, etc. connected to and inserted into these terminals, etc.

In the video game device 1 having the above-described internal structure, when main power switch 32B is turned on and power switch 16 is pressed, CPU 51 of the control system executes the operating system recorded in the ROM to thereby control the video game devices 1. Thereafter, CPU 51 controls the aforesaid graphic system, sound system, etc.

When the operating system is executed, CPU 51 initializes the video game device 1 as a whole, including confirming its operation, etc., then controls the disk device 11 and executes a game or other application program recorded on the optical disk. By executing the game or other program, CPU 51 controls the graphic system and sound system, etc. in accordance with input from the users and controls the display of images and the generation of sound effects and background music.

When this is done, the heat generated by CPU 51 is transmitted along heat conducting member 52 and the rectangular heat sink 54 and is dissipated inside the device 1. The heat that is released is discharged by exhaust fan 15 outside of device 1, together with the heat generated from power source unit 12 and the heat generated from disk device 11.

Rectangular sink 54, CPU 51, and power source unit 12, etc. are cooled by the cooling air sucked into device 1 through opening 6A. This improves the cooling efficiency inside device 1. After the cooling air cools the interior of device 1, it is directed by guide plate 31C, etc. and is exhausted through exhaust opening 41A to the rear side of device 1 by exhaust fan 15.

### (3) Cabinet assembly structure

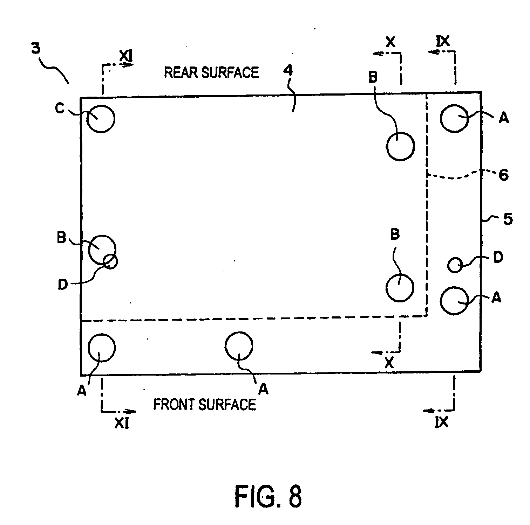

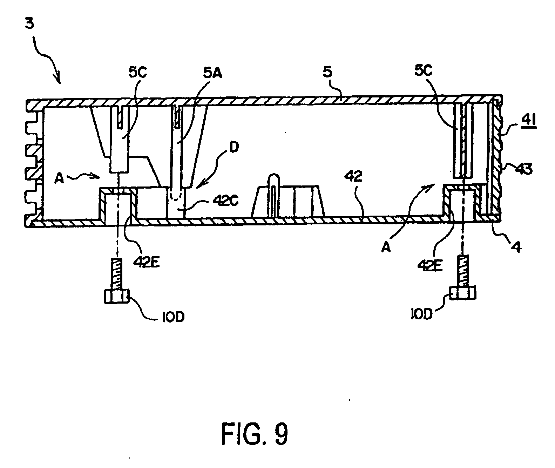

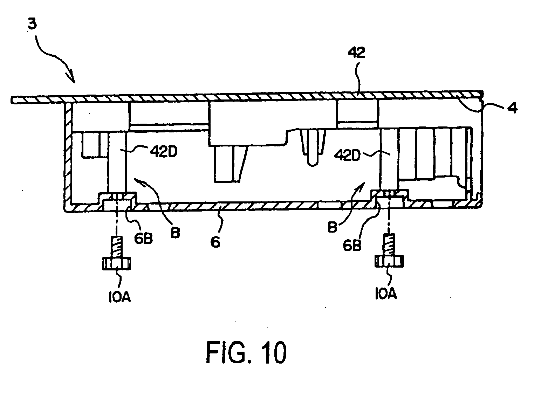

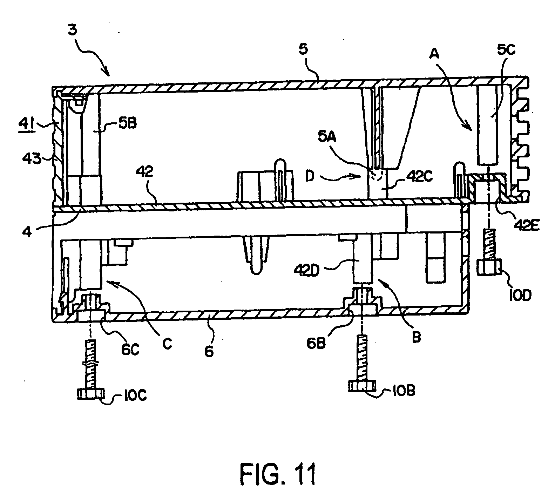

Figures 8 toll show the assembly structure of cabinet 3. Figure 8 is a schematic diagram of upper case 5, central chassis 4, and lower case 6; Figures 9 and 10 are cross-sectional views of those parts in Fig. 8, seen from the right front side, and Figure 11 is a cross-sectional view of those parts in Fig. 8, seen from the left front side.

Provided on the inside surface of upper case 5 are rod-like protrusions 5A pointing toward central chassis 4. The tips of protrusions 5A fit into receptacles 42C, which are fixed to the upper surface of central chassis 4 (the places shown by circles D in Figure 8).

Multiple screw holes 42E into which screws 10D are to be inserted, are formed in the lower surface of central chassis 4. Arranged above screw holes 42E are spacers 5C that protrude downward from the inside surface of the upper case. Threading is formed inside spacers 5C (the places shown by circles A in Figure 8).

That is, upper case 5 and central chassis 4 are made integral by fitting together protrusions 5A and receptacles 42C, inserting screws 10D through screw holes 42E, and screwing screws 10D into the threading of spacers 5C.

As shown in Figure 10, multiple screw holes 6B into which screws 10A, 10B are to be inserted, are formed on the lower surface of lower case 6. Arranged above the screw holes 6B are spacers 42D that protrude downward from the lower surface of central chassis 4. Threading is formed inside spacers 42D. Therefore lower case 6 and central chassis 4 are made integral by inserting screws 10A, 10B through screw holes 6B and screwing screws 10A, 10B into the threading of spacers 42D (the places shown by circles B in Figure 8).

As shown in Figure 11, above some of screw holes 6B, specifically above screw hole 6C, there is provided a through spacer 5B that protrudes from the inside surface of upper case 5 through central chassis 4 to the screw hole 6C. That is, lower case 6, central chassis 4, and upper case 5 are integrally connected (made integral) by putting screw 10C through screw hole 6C and screwing screw 10 C into the threading of through spacer 5B (the place shown by circle C in Figure 8).

### (4) Setting up the device

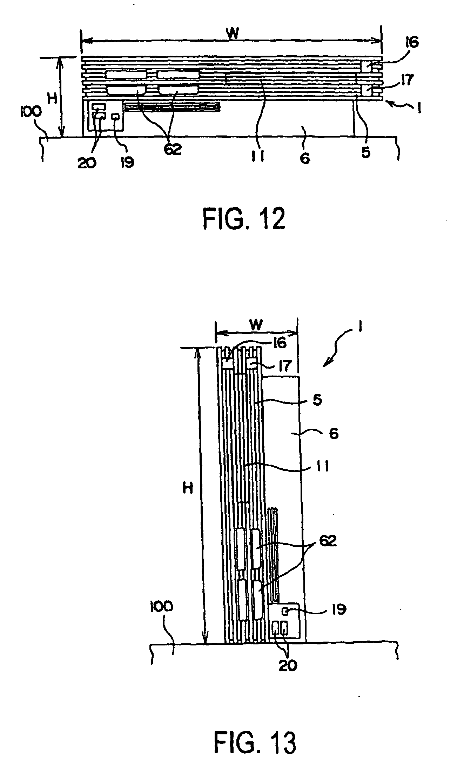

Figures 12 and 13 show the setup structure of video game device 1. Figure 12 is a front view showing the horizontal orientation, and Figure 13 is a front view showing the vertical orientation.

The horizontal orientation is the state (as shown in Figure 12), in which the device 1 is set up on floor 100 with width W as the maximum dimension and height H as the minimum dimension, where the width is denoted by W and the height by H.

Similarly, the vertical orientation is the state (as shown in Figure 13) in which the device 1 is set up on floor 100 with width W as the minimum dimension and height H as the maximum dimension, where the width is denoted by W and the height by H. At this time, the side surface where the surfaces of upper case 5 and lower case 6 match in horizontal orientation becomes the lower surface that comes into contact with the floor.

By setting it up in this way, video game device 1 can be used in horizontal orientation and vertical orientation.

When device 1 is put into vertical orientation, controller connection unit 62, which is exposed on the front left of upper case 5 in horizontal orientation, is exposed at the bottom of the front surface, which becomes the side of cabinet 3 that extends along the height direction, that is, it becomes exposed on the bottom side of the front surface of upper case 5 in the height direction. Also, when device 1 is put into vertical orientation, AC inlet 32A, to which the power cable is connected, is exposed at the bottom of the rear surface of cabinet that extends along the height direction, that is, it becomes exposed on the bottom side of the rear surface part 41 in the height direction. (Figure 3).

Meanwhile, power switch 16 and tray operation switch 17, which are exposed on the front right side of upper case 5 in horizontal orientation, become, when device 1 is put into vertical orientation, exposed on the top side of cabinet 3, that is, on the front of upper case 5 in the height direction.

When putting device 1 into vertical orientation, controller connection unit 62 and AC inlet 32A located are at the bottom of device 1, so, as shown in Figure 14, controller cable 102 and power cable 103, etc., which are connected to them and extend from controller 101, are placed to lie on floor 100.

The present invention has the following effects:
Namely, with video game device 1 in vertical orientation, controller connection unit 62 and AC inlet 32A are positioned arranged at the bottom of device 1, and thus even if a foot catches on power cable 103 or controller cable 102, etc., which are connected to them, the angular moment imparted to device 1 will be small, thereby making it more difficult to cause device 1 to tip over than with conventional devices of the type under consideration.

Also, with video game device 1 in vertical orientation, controller connection unit 62 is provided in position at the bottom of the device 1, so even if controller cable 102 is pulled with a strong force while playing a competitive or shooting game, etc., the angular moment imparted on the device 1 will be small, and in this respect too, it will be more difficult to cause the device 1 to tip over.

In addition, with video game device 1 in vertical orientation, power switch 16 and tray operation switch 17 will be positioned at the top of device 1, making them more visible than if positioned at the bottom, and improving the operability when one operates the power switch 16 and tray operation switch 17.

This invention is not limited to the above embodiment but includes other arrangements, etc. that can achieve the purposes of this invention, including modifications such as the following.

For example, for the operation means, they are not limited to being exposed at the top front of upper case 5; for example, when put in vertical orientation, they may be exposed on the upper surface of upper case 5; in other words, at the top of cabinet 3 in vertical orientation.

Controller connection unit 62 and AC inlet 32A need not be at the bottom of the front of cabinet 3 extending in the height direction when in vertical orientation; they may be at the bottom of a side surface that is perpendicular to the front surface.

Also, the terminals are not limited to controller connection unit 62 and AC inlet 32A; they may be ones to which the cables of data transfer terminal 19 and external device connection terminal 20, etc. are connected.

As stated above, the electronic device of the present invention has the effect of making it difficult to cause it to tip over even if one pulls on a cable when the device is in vertical orientation.

The electronic device of this invention also improves operability even in vertical orientation.

## Claims

1. An electronic device comprising:
a cabinet (3) and
a main body (2) accommodated inside said cabinet and comprising a disk device (11) and a power source unit (12) both accommodated in said cabinet (3),
wherein one of width, height, and depth dimensions of said cabinet is taken as a minimum dimension thereof and another of said width, height and depth dimensions is taken as a maximum dimension thereof,
wherein said cabinet (3) can be used in horizontal orientation, in which said minimum dimension is the height thereof, and in vertical orientation, in which the maximum dimension is said height,
wherein said cabinet (3) includes an upper case (5) and a lower case (6), and is formed so that in the horizontal orientation the width and depth of said lower case (6) are smaller than the width and depth of said upper case (5), and in the vertical orientation bases of said upper case (5) and lower case (6) match on same plane,
wherein, in the horizontal orientation of the cabinet (3), the width and depth of said lower case (5) are smaller than the width and depth of said upper case (6), and the cabinet is such that in the vertical orientation bases of said upper case and said lower case match on same plane, and
wherein said disk device (11) in the vertical orientation of said cabinet (3) is placed toward the top of the cabinet (3), and the power source unit (12) in the vertical orientation of said cabinet (3) is placed toward the bottom of the cabinet (3) whereby the center of gravity of the device is in a relatively low position in the vertical orientation, thereby increasing the stability of the device.

2. The electronic device of claim 1, further comprising terminals (21, 22, 62, 32A) to which cables for external input and output are connected, said terminals being exposed at the bottom of a side of said cabinet (3) that extends along a height direction of said vertical orientation and wherein said terminals are terminals (32A) for power supply that supply electric power from an external power source to said main body.

3. The electronic device of claim 2, wherein said terminals are input-output terminals (62) for inputting input signals and outputting output signals.

4. The electronic device of claim 1, further comprising operation means (16, 17) for operating said main body (2), said operation means being exposed at the top of said cabinet (3) in said vertical orientation.

## Patentansprüche

1. Elektronische Vorrichtung, mit:
einem Gehäuse (3) und
einem Hauptkörper (2), der in dem Gehäuse aufgenommen ist und eine Plattenvorrichtung (11) sowie eine Stromquelleneinheit (12), die beide in dem Gehäuse (3) untergebracht sind, enthält,
wobei entweder die Breiten-, die Höhen- oder die Tiefenabmessung des Gehäuses als dessen minimale Abmessung angesehen wird und eine andere der Breiten-, der Höhen- und der Tiefenabmessung als dessen maximale Abmessung angesehen wird,
wobei das Gehäuse (3) in einer horizontalen Orientierung, in der die minimale Abmessung seine Höhe ist, und in einer vertikalen Orientierung, in der die maximale Abmessung seine Höhe ist, verwendet werden kann,
wobei das Gehäuse (3) einen oberen Kasten (5) und einen unteren Kasten (6) aufweist und so geformt ist, dass die Breite und die Tiefe des unteren Kastens (6) in der horizontalen Orientierung kleiner sind als die Breite und die Tiefe des oberen Kastens (5) und in der vertikalen Orientierung die Grundflächen des oberen Kastens (5) und des unteren Kastens (6) auf derselben Ebene übereinstimmen,
wobei in der horizontalen Orientierung des Gehäuses (3) die Breite und die Tiefe des unteren Kastens (5) kleiner sind als die Breite und die Tiefe des oberen Kastens (6) und das Gehäuse so beschaffen ist, dass in der vertikalen Orientierung die Grundflächen des oberen Kastens und des unteren Kastens auf derselben Ebene übereinstimmen, und
wobei die Plattenvorrichtung (11) in der vertikalen Orientierung des Gehäuses (3) zu der Oberseite des Gehäuses (3) hin angeordnet ist und die Stromquelleneinheit (12) in der vertikalen Orientierung des Gehäuses (3) zu der Unterseite des Gehäuses (3) hin angeordnet ist, wobei sich in der vertikalen Orientierung der Schwerpunkt der Vorrichtung in einer verhältnismäßig niedrigen Position befindet, wodurch die Stabilität der Vorrichtung erhöht wird.

2. Elektronische Vorrichtung nach Anspruch 1, die ferner Anschlüsse (21, 22, 62, 32A) enthält, mit denen Kabel für die Eingabe von und die Ausgabe nach außen verbunden sind, wobei die Anschlüsse am unteren Ende einer Seite des Gehäuses (3), die sich in Höhenrichtung der vertikalen Orientierung erstreckt, freiliegen und wobei die Anschlüsse Anschlüsse (32A) für die Stromversorgung sind, die dem Hauptkörper elektrischen Strom von einer externen Stromquelle zuführen.

3. Elektronische Vorrichtung nach Anspruch 2, wobei die Anschlüsse Eingabe-/Ausgabe-Anschlüsse (62) sind, um Eingangssignale einzugeben und um Ausgangssignale auszugeben.

4. Elektronische Vorrichtung nach Anspruch 1, die ferner Bedienungsmittel (16, 17) enthält, um den Hauptkörper (2) zu bedienen, wobei die Bedienungsmittel in der vertikalen Orientierung an der Oberseite des Gehäuses (3) freiliegen.

## Revendications

1. Dispositif électronique comprenant :
un cabinet (3) et
un corps principal (2) logé à l'intérieur dudit cabinet et comprenant un dispositif de disque (11) et une unité de source de puissance (12) dont les deux sont logés dans ledit cabinet (3),
dans lequel une dimension prise parmi une dimension de largeur, une dimension de hauteur et une dimension de profondeur dudit cabinet est prise en tant que dimension minimum et une autre dimension prise parmi ladite dimension de largeur, ladite dimension de hauteur et ladite dimension de profondeur est prise en tant que dimension maximum dudit cabinet,
dans lequel dit cabinet (3) peut être utilisé selon une orientation horizontale, où ladite dimension minimum est sa hauteur et selon une orientation verticale, où la dimension maximum est ladite hauteur,
ledit cabinet (3) inclut un carter supérieur (5) et un carter inférieur (6) et est formé de telle sorte que, suivant une orientation horizontale, la largeur et la profondeur dudit carter inférieur (6) soient inférieures à la largeur et à la profondeur dudit carter supérieur (5) et que, suivant l'orientation verticale, des bases dudit carter supérieur (5) et dudit carter inférieur (6) se correspondent sur le même plan, et
ledit dispositif de disque (11) suivant une orientation verticale dudit cabinet (3) est placé en direction du sommet du cabinet (3), et l'unité de source de puissance (12) suivant une orientation verticale dudit cabinet (3) est placée en direction du fond du cabinet(3), où le centre de gravité du dispositif est dans une position relativement basse suivant une orientation verticale, augmentant ainsi la stabilité du dispositif.

2. Dispositif électronique selon la revendication 1, comprenant en outre des bornes (21, 22, 62, 32A) sur lesquelles des câbles pour une entrée et une sortie externes sont connectés, lesdites bornes étant exposées au niveau du fond d'un côté dudit cabinet (3) qui s'étend suivant une direction de hauteur de ladite orientation verticale et dans lequel lesdites bornes sont des bornes (32A) pour alimenter une puissance électrique d'alimentation depuis une source de puissance externe sur ledit corps principal.

3. Dispositif électronique selon la revendication 2, dans lequel lesdites bornes sont des bornes d'entrée-sortie (62) pour entrer des signaux d'entrée et pour émettre en sortie des signaux de sortie.

4. Dispositif électronique selon la revendication 1, comprenant en outre un moyen d'opération (16, 17) pour actionner ledit corps principal (2), ledit moyen opération étant exposé au niveau du sommet dudit cabinet (3) suivant ladite orientation verticale.
